# EUROPEAN PATENT APPLICATION

(11) **EP 3 517 183 A1**
(43) Date of publication of application: **31.07.2019**
(21) Application number: 19153517.8
(22) Date of filing: 24.01.2019
(51) Int. Cl.: A62C 35/58, A62C 99/00, A62C 37/50, G06F 17/50

(54) **DESIGN METHOD FOR FIRE EXTINGUISHING SPRINKLER SYSTEMS**

(30) Priority: 24.01.2018 US 201862621208 P
(71) Applicant: Carrier Corporation, Palm Beach Gardens, FL 33418 (US)
(72) Inventor: CAO, Changmin, Pudong, Shanghai 201204 (CN); SNYDER, Jordan A., East Hartford, CT 06108 (US); CORN, May L., East Hartford, CT 06108 (US); JOHNSON, Paul M., Ashland, MA 01721 (US); MOROZOV, Mikhail, Ashland, MA 01721 (US); SENECAL, Joseph Albert, Ashland, MA 01721 (US); SANKARAN, Vaidyanathan, East Hartford, CT 06108 (US)
(74) Representative: Dehns

(57) **Abstract**

A method (100) and a system (300) for determining fire suppression system characteristics is disclosed. The method includes receiving input information regarding one or more nozzles (102); receiving input information regarding a fire suppression agent (104); receiving input information regarding a room to be protected by the fire suppression system (106); iterating through a plurality of scenarios to determine fire suppression characteristics of each scenario (108); determining coverage of the room to be protected for each of the plurality of scenarios (110); and ranking each scenario of the plurality of scenarios based on the fire suppression characteristics (114).

## Description

### BACKGROUND

Exemplary embodiments pertain to the art of computing. In particular, the present disclosure relates to a method and system for determining the coverage of a nozzle.

Fire protection systems are typically qualified under one or more certification schemes such as, for example, FM5600, UL2126 and/or UL2127. A fire suppression system utilizes a variety of methods to suppress fires. In some systems, one or more nozzles are used to spread a fire suppressing agent throughout a defined space such as a room, hallway, subfloor, or other defined area. One determinant for qualification under certification schemes is the degree of room dispersion for a particular installation, such that a space is adequately protected by the coverage provided by the installed system. Coverage may depend in part on nozzle placement, performance, and suppression agent flow. Testing for room coverage is expensive and time consuming.

It can be desirable to have a method and system for quickly determining characteristics of a fire suppression system. For example, determining the spread and penetration of fire suppression agent, based on nozzle design and nozzle placement can be desirable. However, because of the large number of parametric variations that can be considered for any given fire suppression system installation, consideration of sufficient factors to accurately model the output of various multiple alternatives for a proposed or deployed system has been impractical due to the computational requirements for even one such model, let alone multiple alternatives.

### BRIEF DESCRIPTION

According to one embodiment, a method for determining fire suppression system characteristics is disclosed. The method includes receiving input information regarding one or more nozzles; receiving input information regarding a fire suppression agent; receiving input information regarding a room to be protected by the fire suppression system; iterating through a plurality of scenarios to determine fire suppression characteristics of each scenario; determining coverage of the room to be protected for each of the plurality of scenarios; and ranking each scenario of the plurality of scenarios based on the fire suppression characteristics.

According to one embodiment, a system for determining fire suppression system characteristics is disclosed. The system includes a processor and a memory. The processor is configured to perform a method, which may be a method as set out above and optionally including steps as defined below. The method includes receiving input information regarding one or more nozzles; receiving input information regarding a fire suppression agent; receiving input information regarding a room to be protected by the fire suppression system; iterating through a plurality of scenarios to determine fire suppression characteristics of each scenario; determining coverage of the room to be protected for each of the plurality of scenarios; and ranking each scenario of the plurality of scenarios based on the fire suppression characteristics.

The fire suppression characteristics may comprise penetration of the fire suppression agent and vaporization of the fire suppression agent.

The input information regarding one or more nozzles may comprise one or more of the following: orifice layout, size of orifice, shape of orifice, number of nozzles, and placement of nozzles.

The input information regarding the fire suppression agent may comprise one or more of the following: properties of the agent, temperature of the agent, amount of the agent.

The input information regarding the room to be protected may comprise one or more of the following: dimensions of the room, contents of the room, materials of the room, and layout of the room.

The layout of the room may comprise a shape of the room and is input using a graphical user interface.

The contents of the room may be input using the graphical user interface.

Iterating through the plurality of scenarios may comprise: changing one or more of the input information of the one or more nozzles; and determining the coverage of the room based on the changed input information.

The method for determining fire suppression system characteristics may include generating a visualization of the coverage of the room to be protected for each of the plurality of scenarios.

The method for determining fire suppression system characteristics may include forwarding information to a computation field dynamics simulator to assess the spatio-temporal evolution of injection, vaporization, and dispersion of the agent into the room.

The method for determining fire suppression system characteristics may include generating contour maps and line plots configured to assess dispersion of the agent.

The method for determining fire suppression system characteristics may include using the computation field dynamics simulator to assess one or more of the following: agent concentration dispersion, conversion of agent to vapor, mean concentration mixedness, and amount of agent lost.

### BRIEF DESCRIPTION OF THE DRAWINGS

The following descriptions should not be considered limiting. With reference to the accompanying drawings, like elements are numbered alike:
FIG. 1 is a flowchart illustrating the operation of a reduced order model;
FIG. 2 is a flowchart illustrating the operation of a computational fluid dynamics model;
FIG. 3 is a block diagram illustrating an exemplary computer system; and
FIG. 4 illustrates a computer program product.

### DETAILED DESCRIPTION

A detailed description of one or more embodiments of the disclosed apparatus and method are presented herein by way of exemplification and not limitation with reference to the Figures.

Fire suppression systems are of great importance for the safety of people and the protection of valuable equipment. A fire suppression system often involves the distribution of a fire suppression agent over an area that is on fire or threatened with fire. The fire suppression agent may be a combination of dry chemicals or wet agents to extinguish or prevent the spread of fire. Exemplary fire suppression agents may include a fire protection fluid, Novec 1230, Halon, clean agent FS 49 C2, pentafluoroethane, aragonite, carbon dioxide, IG-541, IG-100, and other agents.

There are a variety of methods of distributing a fire suppression material. For small fires, portable fire extinguishers are often used. These involve a canister in a portable size that is attached to a nozzle. A user manually activates the nozzle and sprays the fire suppression material at the fire.

To protect larger areas or to provide automated fire protection, an installed fire suppression system may be used. An installed fire suppression system uses one or more nozzles installed on a wall or ceiling of an area. Coupled to the nozzles are supplies of fire suppression agent. Upon the detection of a fire or potential fire, the fire suppression system disperses the fire suppression agent through the one or more nozzles.

To ensure that an installed system is capable of adequate fire protection for a given space a fire suppressing agent must be dispersed through the space to a degree sufficient to provide coverage for the entire space. A space may be any area meant to be protected by an installed fire suppression system such as a room, a portion of a room (for example, an area which contains one or more assets that are desirable to protect from damage), hallway, subfloor, or other defined area, including an open area where fire suppression is feasible and desirable; for purposes of this disclosure, the terms "space", "room", and "area" should be understood to include all of these and to be interchangeable.

In order to properly analyze such a fire suppression system, it is desirable to use computational simulations of the nozzle performance. However, existing computational simulations are computationally intensive, because of the large number of parametric variations that can be considered for nozzle design, such as orifice size, number of nozzles, placement of nozzles, pressure of fire suppression material, characteristics of fire suppression material, and the like.

In one or more embodiments, the above-described issues are addressed by using a reduced order model to provide a rapid survey of the parametric variations and to determine a few key cases for more detailed simulations. Thereafter, a computational fluid dynamics model may be used to present a more thorough assessment of the dispersion of the fire suppression material.

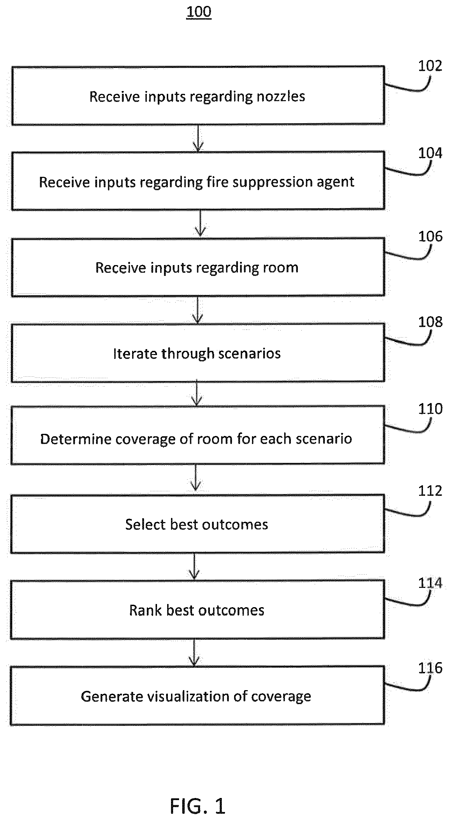

With respect to FIG. 1, a method 100 is presented that illustrates the operation of a reduced order model (ROM) in one or more embodiments. Method 100 is merely exemplary and is not limited to the embodiments presented herein. Method 100 may be employed in many different embodiments or examples not specifically depicted or described herein. In some embodiments, the procedures, processes, and/or activities of method 100 may be performed in the order presented. In other embodiments, one or more of the procedures, processes, and/or activities of method 100 may be combined, skipped, or performed in a different order.

The objective of the ROM is to conduct a wide-ranging parametric study to determine the effect of nozzle design parameters on the measured metrics. Key metrics may include jet penetration and vaporization. Jet penetration refers to the distance away from the orifice in which a certain fraction of the fire suppression agent (also referred to as a fire suppression material, dispersed agent, or agent) remains coherent. It is desirable to have a jet penetration value within a desired range. A jet penetration that is too small can have negative consequences in that it is desirable to have the fire suppression material reach all areas of a room. A jet penetration that is too large can have negative consequences in that fire suppression agent is lost to a wall or other obstruction, and/or loses momentum and mixing effectiveness. For deployment schemes where agent vaporization is expected it is typically desirable to have complete vaporization of the agent.

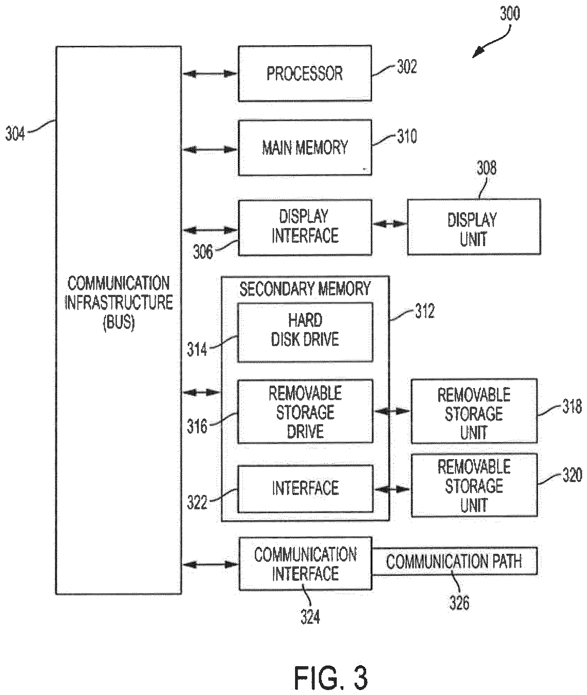

The ROM receives various inputs regarding the nozzle (block 102). This information may include orifice layout, size of the nozzle and orifice, shape of orifice, number of nozzles, and placement of nozzles. The ROM receives inputs regarding the agent (block 104). This information may include inherent properties of the agent, temperature, amount and pressure of agent, and the like. The inputs can be entered in one of a variety of different manners. As will be discussed below with respect to FIG. 3, a computer system 300 can be used to receive the inputs. In such an embodiment, the inputs can be manually entered by a user through a variety of interfaces, such as a graphical user interface, or a keyboard and mouse. In other embodiments, inputs can be automatically transmitted from another computer system via a communication interface.

The ROM receives inputs regarding the room (block 106). This may include generic information, such as the dimensions of the room, and the materials of the room. In some embodiments, additional information may include layout of the room. The layout of the room may be provided in a computer-aided drawing (CAD) like manner, in which the walls, floor, and ceiling of the room are set forth. The layout also may include fixtures and furniture. Such layout information may be of importance when the purpose of the fire suppression system is to protect sensitive equipment, such as computer servers and other large, valuable equipment. The dimensions and location of the equipment are input into the system.

The inputting of this information may be in the form of a graphical user interface (GUI) in which a user "draws" the location of the furniture and fixtures, as well as the dimensions of the room.

The ROM processes the information and determines output of the nozzles based on the inputted information. The ROM iterates through a variety of scenarios (block 108) and determines the coverage of the room based on the inputs (block 110). Each scenario determined by the ROM is different depending on variations upon the input information. Variations may be driven by differences in the system installation configuration. For example, there may be different placement of a nozzle. There may be different numbers of nozzles. There may be different characteristics of the nozzle. There may be different characteristics of the fire suppression material. Each iteration changes at least one factor and determines a resulting output of the fire suppression material in the room. In addition, based on an input pressure of the agent and the amount of piping, the pressure at each nozzle may be determined and used as part of the calculations.

The ROM selects the best outcomes based on calculated penetration and vaporization (block 112). The ROM may rank the results based on those criteria (block 114). In addition, a visualization of the coverage and penetration of the nozzles in the room may be generated (block 116). This may involve the generation of drawings which illustrate the coverage of various situations. For example, if one were designing a fire protection system for a server room, the output could be one or more an illustrated layouts of the server room. Each of the layouts may show placement of each nozzle and the coverage of each nozzle and the resulting coverage of each nozzle. In such a manner, a user may quickly determine the best placement and characteristics of the nozzles.

Thereafter, a user could then use one or more tools to perform more detailed calculations to determine an optimum solution. For example, the user could perform further analyses on one or more of the predicted best outcomes by using computation field dynamics (CFD) simulations.

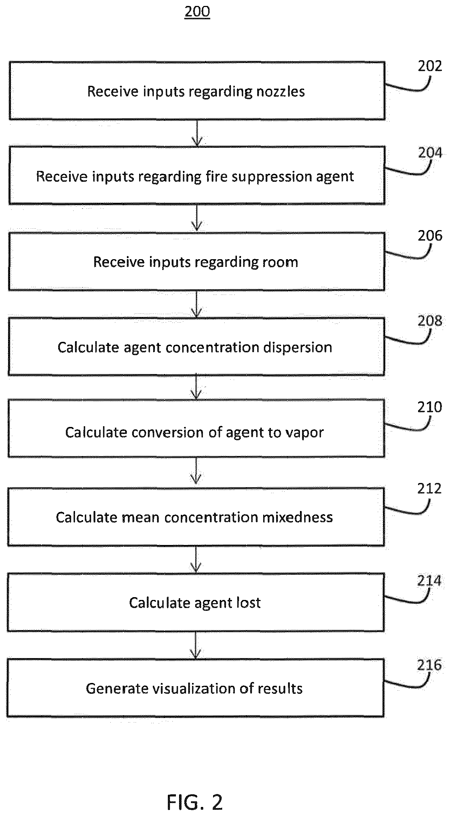

With respect to FIG. 2, a method 200 is presented that illustrates the operation of a CFD simulation in one or more embodiments. Method 200 is merely exemplary and is not limited to the embodiments presented herein. Method 200 may be employed in many different embodiments or examples not specifically depicted or described herein. In some embodiments, the procedures, processes, and/or activities of method 200 may be performed in the order presented. In other embodiments, one or more of the procedures, processes, and/or activities of method 200 may be combined, skipped, or performed in a different order.

The objective of the CFD simulation is to conduct a detailed simulation for the most important cases as identified by the ROM, to assess the spatio-temporal evolution of the injection, vaporization, and dispersion of the agent into the room. While the ROM is a simplified version and can be performed by a less powerful desktop computer, a CFD is more computationally intensive, and may require specialized hardware to perform.

The CFD receives the information cases selected from the ROM process. Because the CFD may require specialized hardware to perform, in some embodiments the CFD may reside on a remote server that includes or is communicatively connected to specialized hardware sufficient to perform the CFD, and where the server is communicatively connected to a device local to a user and receives the information from the device local to the user.

The information received by the CFD may include various inputs regarding the nozzle (block 202). The CFD also may receive information regarding orifice layout, size of the nozzle and orifice, shape of orifice, and number of nozzle. The CFD receives inputs regarding the agent (block 204). This information may include inherent properties of the agent, pressure of the agent, temperature, amount of agent, and the like. The CFD model uses correlations to define the fluid properties, jet velocity, and spray distributions, given the input conditions.

The CFD receives inputs regarding the room (block 206). This information may be the same drawing information input for the ROM.

Using this information, the CFD performs a detailed analysis of the agent injection, vaporization, and dispersion into the room. The analysis may include an analysis over time (e.g., how the agent is dispersed over a longer time period, such as 3 minutes, 5 minutes, or longer).

The calculations performed by the CFD produce several outputs, including an assessment of the agent concentration dispersion (block 208), the conversion of the agent to vapor (block 210), the mean concentration mixedness (block 212), and amount of agent lost (e.g., agent lost to the walls or floor that do not reach other areas of the room (block 214).

A result may be presented graphically (block 216). A graphical result may include contour maps and line plots that may be used to assess the dispersion of the agent.

While embodiments may be used to plan fire control systems, embodiments also may be used to design nozzles for use in fire control systems. As described above, characteristics of the nozzles, such as pressure of the agent, nozzle aperture opening, and the like, may be supplied as inputs to the ROM and CFD. While this may include already existing nozzle designs, it also may include proposed nozzle designs. By using proposed nozzle designs in various applications, one may determine if a potential nozzle design is appropriate for certain cases or not.

FIG. 3 depicts a high-level block diagram of a computer system 300, which may be used to implement one or more embodiments. More specifically, computer system 300 may be used to implement hardware components of systems capable of performing methods described herein. Although one exemplary computer system 300 is shown, computer system 300 includes a communication path 326, which connects computer system 300 to additional systems (not depicted) and may include one or more wide area networks (WANs) and/or local area networks (LANs) such as the Internet, intranet(s), and/or wireless communication network(s). Computer system 300 and additional system are in communication via communication path 326, e.g., to communicate data between them. While numerous components are illustrated in FIG. 3, some embodiments might not include every illustrated component. The inputs and calculations discussed above with respect to FIGs. 1 and 2 can be performed on computer system 300.

Computer system 300 includes one or more processors, such as processor 302. Processor 302 is connected to a communication infrastructure 304 (e.g., a communications bus, cross-over bar, or network). Computer system 300 may include a display interface 306 that forwards graphics, textual content, and other data from communication infrastructure 304 (or from a frame buffer not shown) for display on a display unit 308. Computer system 300 also includes a main memory 310, preferably random access memory (RAM), and may also include a secondary memory 312. Secondary memory 312 may include, for example, a hard disk drive 314 and/or a removable storage drive 316, representing, for example, a floppy disk drive, a magnetic tape drive, or an optical disc drive. Hard disk drive 314 may be in the form of a solid state drive (SSD), a traditional magnetic disk drive, or a hybrid of the two. There also may be more than one hard disk drive 314 contained within secondary memory 312. Removable storage drive 316 reads from and/or writes to a removable storage unit 318 in a manner well known to those having ordinary skill in the art. Removable storage unit 318 represents, for example, a floppy disk, a compact disc, a magnetic tape, or an optical disc, etc. which is read by and written to by removable storage drive 316. As will be appreciated, removable storage unit 318 includes a computer-readable medium having stored therein computer software and/ or data.

In alternative embodiments, secondary memory 312 may include other similar means for allowing computer programs or other instructions to be loaded into the computer system. Such means may include, for example, a removable storage unit 320 and an interface 322. Examples of such means may include a program package and package interface (such as that found in video game devices), a removable memory chip (such as an EPROM, secure digital card (SD card), compact flash card (CF card), universal serial bus (USB) memory, or PROM) and associated socket, and other removable storage units 320 and interfaces 322 which allow software and data to be transferred from the removable storage unit 320 to computer system 300.

Computer system 300 may also include a communications interface 324. Communications interface 324 allows software and data to be transferred between the computer system and external devices. Examples of communications interface 324 may include a modem, a network interface (such as an Ethernet card), a communications port, or a PC card slot and card, a universal serial bus port (USB), and the like. Software and data transferred via communications interface 324 are in the form of signals that may be, for example, electronic, electromagnetic, optical, or other signals capable of being received by communications interface 324. These signals are provided to communications interface 324 via communication path (i.e., channel) 326. Communication path 326 carries signals and may be implemented using wire or cable, fiber optics, a phone line, a cellular phone link, an RF link, and/or other communications channels.

In the present description, the terms "computer program medium," "computer usable medium," and "computer-readable medium" are used to refer to media such as main memory 310 and secondary memory 312, removable storage drive 316, and a hard disk installed in hard disk drive 314. Computer programs (also called computer control logic) are stored in main memory 310 and/or secondary memory 312. Computer programs also may be received via communications interface 324. Such computer programs, when run, enable the computer system to perform the features discussed herein. In particular, the computer programs, when run, enable processor 302 to perform the features of the computer system. Accordingly, such computer programs represent controllers of the computer system. Thus it may be seen from the forgoing detailed description that one or more embodiments provide technical benefits and advantages.

A user can utilize one or more of the above interfaces to enter data. For example, a user can use a mouse/keyboard combination that is communicatively coupled via a communication interface 324, such as a mouse and keyboard connected via USB. Data can be transmitted from external computer systems, coupled to computer system 300 via communication interface 324. A user can utilize display interface 306 to view the data being entered into computer system 300. Data can be previously stored on a storage medium, such as hard disk drive 314.

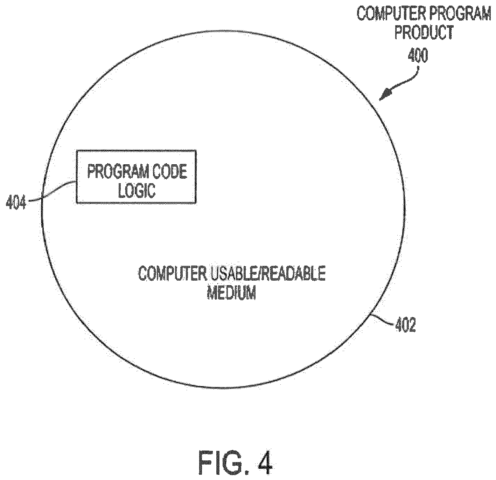

Referring now to FIG. 4, a computer program product 400 in accordance with an embodiment that includes a computer-readable storage medium 402 and program instructions 404 is generally shown.

Embodiments may be a system, a method, and/or a computer program product. The computer program product may include a computer-readable storage medium (or media) having computer-readable program instructions thereon for causing a processor to carry out aspects of embodiments of the present invention.

The computer-readable storage medium may be a tangible device that may retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer-readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer-readable program instructions described herein may be downloaded to respective computing/processing devices from a computer-readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers, and/or edge servers. A network adapter card or network interface in each computing/processing device receives computer-readable program instructions from the network and forwards the computer-readable program instructions for storage in a computer-readable storage medium within the respective computing/processing device.

Computer-readable program instructions for carrying out embodiments may include assembler instructions, instruction-set-architecture (ISA) instructions, machine instructions, machine dependent instructions, microcode, firmware instructions, state-setting data, or either source code or object code written in any combination of one or more programming languages, including an object-oriented programming language such as Smalltalk, C++ or the like, and conventional procedural programming languages, such as the "C" programming language or similar programming languages. The computer-readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform embodiments of the present invention.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present invention as defined by the claims. In addition, many modifications may be made to adapt a particular situation or material to the teachings of the present disclosure without departing from the scope thereof. Therefore, it is intended that the present invention not be limited to the particular embodiment invention as the best mode contemplated for carrying out this present invention, but that the present disclosure will include all embodiments falling within the scope of the claims.

## Claims

1. A computer-implemented method (100) for determining fire suppression system characteristics comprising:
receiving input information regarding one or more nozzles (102);
receiving input information regarding a fire suppression agent (104);
receiving input information regarding a room to be protected by the fire suppression system (106);
iterating through a plurality of scenarios to determine fire suppression characteristics of each scenario (108);
determining coverage of the room to be protected for each of the plurality of scenarios (110); and
ranking each scenario of the plurality of scenarios based on the fire suppression characteristics (114).

2. The computer-implemented method of claim 1, wherein:
the fire suppression characteristics comprise penetration of the fire suppression agent and vaporization of the fire suppression agent.

3. The computer-implemented method of claim 1 or claim 2, wherein:
input information regarding one or more nozzles comprises one or more of the following: orifice layout, size of orifice, shape of orifice, number of nozzles, and placement of nozzles.

4. The computer-implemented method of claim 1, 2 or 3 wherein:
input information regarding the fire suppression agent comprises one or more of the following: properties of the agent, temperature of the agent, amount of the agent.

5. The computer-implemented method of any preceding claim, wherein:
input information regarding the room to be protected comprises one or more of the following: dimensions of the room, contents of the room, materials of the room, and layout of the room.

6. The computer-implemented method of claim 5, wherein:
layout of the room comprises a shape of the room and is input using a graphical user interface.

7. The computer-implemented method of claim 6, wherein:
the contents of the room are input using the graphical user interface.

8. The computer-implemented method of any preceding claim, wherein:
iterating through the plurality of scenarios (108) comprises:
changing one or more of the input information of the one or more nozzles; and
determining the coverage of the room based on the changed input information.

9. The computer-implemented method of any preceding claim, further comprising:
generating a visualization of the coverage of the room to be protected for each of the plurality of scenarios (116).

10. The computer-implemented method of any preceding claim, further comprising:
forwarding information to a computation field dynamics simulator to assess the spatio-temporal evolution of injection, vaporization, and dispersion of the agent into the room (200).

11. The computer-implemented method of claim 10, further comprising:
generating contour maps and line plots configured to assess dispersion of the agent (216).

12. The computer-implemented method of claim 10 or claim 11, further comprising:
using the computation field dynamics simulator to assess one or more of the following: agent concentration dispersion (208), conversion of agent to vapor (210), mean concentration mixedness (212), and amount of agent lost (214).

13. A computer system (300) comprising:
a processor (302); and
memory (310,312);
wherein the processor is configured to perform the method as claimed for in any preceding claim.
